# EUROPEAN PATENT APPLICATION

(11) **EP 2 395 665 A1**
(43) Date of publication of application: **14.12.2011**
(21) Application number: 10174599.0
(22) Date of filing: 31.08.2010
(51) Int. Cl.: H03L 7/099, H03L 7/093

(54) **Device and method for locking and calibrating frequency**

(30) Priority: 11.06.2010 TW 099119069
(71) Applicant: Askey Computer Corp., Chung-Ho T'ai pei 23585 (TW)
(72) Inventor: Hung, Kuo-Wei, 807, Kaohsiung City Taiwan 807 (CN); Yang, Shun-Ya, 892, Kinmen County Taiwan 892 (CN); Hsieh, Ching-Feng, 108, Taipei City Taiwan 108 (CN)
(74) Representative: Perani, Aurelio

(57) **Abstract**

A device and a method for locking and calibrating a frequency is provided for receiving a precise external clock frequency to lock an adjustable oscillator that controls an oscillation frequency to a predetermined frequency. The device comprises a process unit and a frequency adjusting unit. The process unit is provided for comparing the oscillation frequency with a precise frequency to generate a frequency difference and a calibration signal according to the frequency difference. The frequency adjusting unit generates a locking voltage according to the comparison result of the calibration signal and the internal oscillation frequency for locking the oscillation frequency of the external adjustable oscillator to the predetermined frequency, so that the adjustable oscillator still can output a precise oscillation frequency without requiring a precise oscillator.

## Description

### FIELD OF THE INVENTION

The present invention relates to devices and methods for locking and calibrating a frequency, in particular to a device and a method for locking and calibrating an external adjustable oscillator to generate a constant frequency output.

### BACKGROUND OF THE INVENTION

In a prior art, it is necessary for two devices or systems to obtain a common frequency (or signal) in order to perform signal communications between the two devices or systems. For example, wide band code division multiple access (WCDMA) third generation (3G) mobile communications adopts a synchronous frequency of 19.2MHz for a device/system switching between a cell phone and the base station. In addition, the synchronous frequency must be very precise up to a level of precision without any deviation at all.

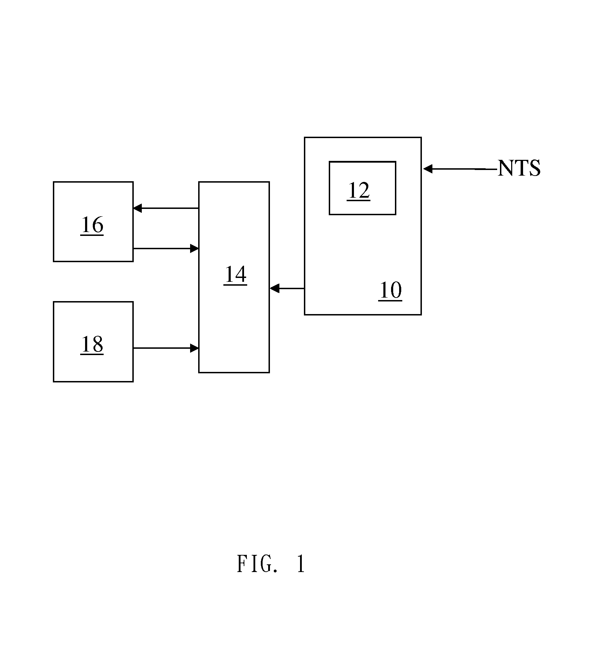

In general, there are several solutions to the aforementioned problem. In a first solution, a very precise frequency oscillation generator is used for generating and providing a precise synchronous frequency required for a system switching between the cell phone and the base station. In a second solution, an embedded network time protocol (NTP) or precision time protocol (PTP) TimeStamp processor is applied, such that the processor can confirm an difference through a standard time of the network, and then the oscillation generator is adjusted by software and provided for assuring the frequency oscillation generator to generate a constant synchronous frequency as shown in FIG. 1. In FIG. 1, a processor 10 with an embedded TimeStamp 12 is provided for receiving a time signal transmitted from a network time server (NTS), and then an algorithm of the processor 10 is used for analyzing the time signal and setting a phase locked loop (PLL) 14. The PLL 14 is used for adjusting a crystal oscillator 16, and a frequency of the crystal oscillator 16 and a frequency of an internal oscillator 18 are transmitted back to the PLL 14 repeatedly, so as to achieve the frequency locking effect.

However, the first solution using a precise frequency oscillation generator incurs a higher cost, and thus it is not suitable for mass production and cannot meet a cost-down requirement. The second solution adopts a special TimeStamp processor, but such processor is not commonly and its application is not popular. Although the processor can confirm the difference between the internal frequency and the frequency of the network time server, the internal oscillator will still have the issue of a deviated frequency, unless the expensive precise oscillation generator is used.

### SUMMARY OF THE INVENTION

It is a primary objective of the present invention to provide a device for locking and calibrating a frequency, wherein the device is used for locking and calibrating an external adjustable oscillator to a predetermined frequency according to a frequency difference, provided to the frequency adjusting unit, produced by comparing an oscillation frequency generated by the external adjustable oscillator with a precise external clock frequency.

Another objective of the present invention is to provide a method for locking and calibrating a frequency, wherein the method is used for locking and calibrating an external adjustable oscillator to a predetermined frequency according to a frequency difference calculated by comparing an oscillation frequency generated by the external adjustable oscillator with a precise external clock frequency.

To achieve the foregoing and other objectives, the present invention provides a device for locking and calibrating a frequency, and the device is used for receiving a precise external clock frequency and an oscillation frequency generated by an external adjustable oscillator, and locking and calibrating the oscillation frequency controlled by a voltage of an external adjustable oscillator to a predetermined frequency. The device comprises a processing unit and a frequency adjusting unit. The processing unit is used for comparing the oscillation frequency with the precise clock frequency to calculate the frequency difference therebetween, and generating a calibration signal according to the frequency difference. The frequency adjusting unit is used for adjusting a locking voltage to lock the oscillation frequency to the predetermined frequency.

To achieve the foregoing and other objectives, the present invention provides a method for locking and calibrating a frequency, and the method is provided for using a voltage for locking an external adjustable oscillator to a predetermined frequency, wherein the external adjustable oscillator controls the oscillation frequency.

The method comprises: receiving an oscillation frequency generated by an external adjustable oscillator; receiving a precise external clock frequency, and comparing the oscillation frequency with the precise external clock frequency to calculate the frequency difference therebetween, and generating a calibration signal according to the frequency difference by an algorithm; and generating a locking voltage according to the calibration signal and the oscillation frequency, and locking the oscillation frequency to the predetermined frequency by using the locking voltage.

Compared with the prior art, the present invention provides a device and a method for locking and calibrating a frequency, and the device and method still can output a predetermined frequency precisely without using a precise frequency oscillator or a processor with an additional hardware mechanism (such as TimeStamp). In other words, the present invention can be applied for the calibration of a predetermined frequency to achieve a precise frequency output without the need of changing the original existing hardware (such as a general processor).

### BRIEF DESCRIPTION OF THE DRAWINGS

FIG. 1 is a schematic view of a conventional frequency calibration system;

FIG. 2 is a schematic view of a device for locking and calibrating a frequency in accordance with a first preferred embodiment of the present invention;

FIG. 3 is a schematic view of a device for locking and calibrating a frequency in accordance with a second preferred embodiment of the present invention; and

FIG. 4 is a flow chart of a method for locking and calibrating a frequency in accordance with a preferred embodiment of the present invention.

### DESCRIPTION OF THE PREFERRED EMBODIMENTS

The objects, characteristics and effects of the present invention will become apparent with the detailed description of the preferred embodiments and the illustration of related drawings as follows.

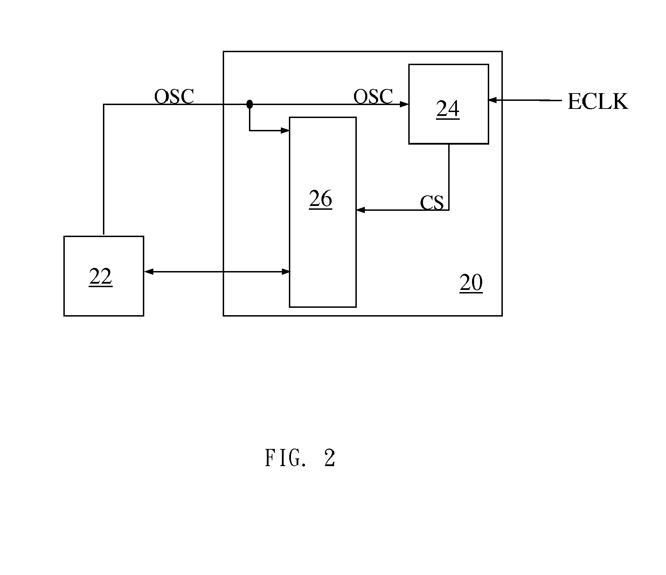

With reference to FIG. 2 for a schematic view of a device 20 for locking and calibrating a frequency in accordance with a first preferred embodiment of the present invention, the device 20 is configured to receive a precise external clock signal ECLK to thereby lock an external adjustable oscillator 22 to a predetermined frequency. The external adjustable oscillator 22 controls an oscillation frequency OSC by a voltage. The precise external clock signal ECLK is a network time protocol-based (NTP-based) clock signal, precision time protocol-based (PTP-based) clock signal, a GPS clock signal, or a set-top-box clock signal. The oscillation frequency OSC generated by the external adjustable oscillator 22 varies with an applied voltage. The external adjustable oscillator 22 is also known as a voltage-controlled oscillator. A voltage controlled temperature compensated crystal oscillator (VCTCXO) is used in this embodiment for illustrating the present invention. In addition to generation of frequency, the voltage controlled temperature compensated crystal oscillator can achieve compensation for temperature-induced frequency variation. In other words, the voltage controlled temperature compensated crystal oscillator is free from a frequency deviation despite a change of temperature. It is noteworthy to point out that the external adjustable oscillator 22 will fall within the scope of the present invention, provided that the external adjustable oscillator 22 is capable of generating a frequency corresponding to an applied voltage.

The device 20 for locking and calibrating a frequency comprises a processing unit 24 and a frequency adjusting unit 26. The processing unit 24 receives the oscillation frequency OSC and the precise external clock frequency, compares the oscillation frequency OSC with the precise external clock frequency to thereby calculate a frequency difference therebetween, and generates a calibration signal CS according to the frequency difference, such that the frequency difference can be used for determining whether or not the oscillation frequency OSC is precise. The oscillation frequency OSC received by the device 20 for locking and calibrating a frequency is the most fundamental required clock unit. If the oscillation frequency OSC of the external adjustable oscillator 22 is precise enough, then any system requiring a precise frequency can be operated at a stable and precise frequency. The frequency adjusting unit 26 is electrically coupled to the processing unit 24 and used for receiving the calibration signal CS and the oscillation frequency OSC, and comparing the calibration signal CS with the oscillation frequency OSC to generate a locking voltage. The locking voltage is used for locking the oscillation frequency OSC generated by the external adjustable oscillator 22 to the predetermined frequency. For example, the predetermined frequency required by a wide band code division multiple access (WCDMA) of a 3G mobile communication is 19.2MHz.

In other words, the frequency adjusting unit 26 stably and precisely locks the oscillation frequency OSC generated by the external adjustable oscillator 22 to the predetermined frequency according to the repeated comparison results of the calibration signal CS with the oscillation frequency OSC. In other words, if the present invention is applied to the 3G mobile communication, then the device for locking and calibrating a frequency 20 will lock the external adjustable oscillator 22 to 19.2MHz.

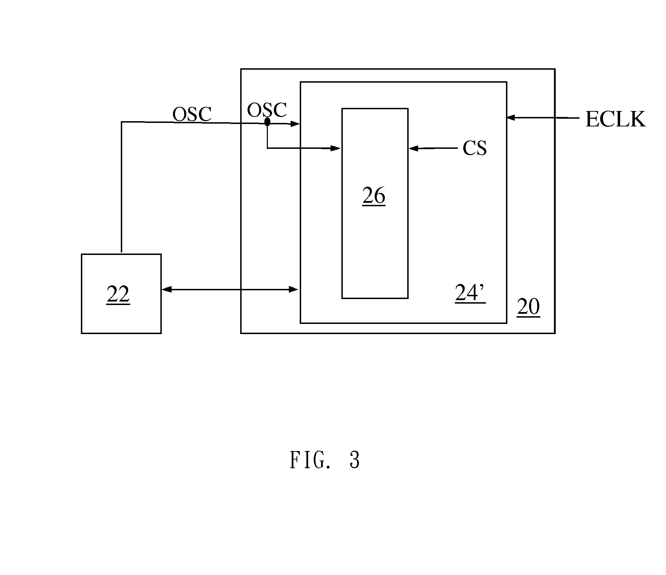

In a second preferred embodiment, the frequency adjusting unit 26 can be embedded into the processing unit 24', and the processing unit 24' with the embedded frequency adjusting unit 26 can provide a locking voltage to lock the oscillation frequency OSC generated by the external adjustable oscillator 22 to the predetermined frequency as shown in FIG. 3, in addition to generating a calibration signal CS corresponding to the frequency difference between the oscillation frequency OSC and the precise external clock frequency.

In summation, the device for locking and calibrating a frequency of the present invention generates the calibration signal according to a frequency (or clock) difference between the precise external clock frequency and the oscillation frequency OSC generated by the external adjustable oscillator 22, and compares the calibration signal with the oscillation frequency OSC again to provide a comparison result to the frequency adjusting unit 26 to generate a locking voltage, so that the oscillation frequency OSC of the external adjustable oscillator 22 can be locked to the predetermined frequency.

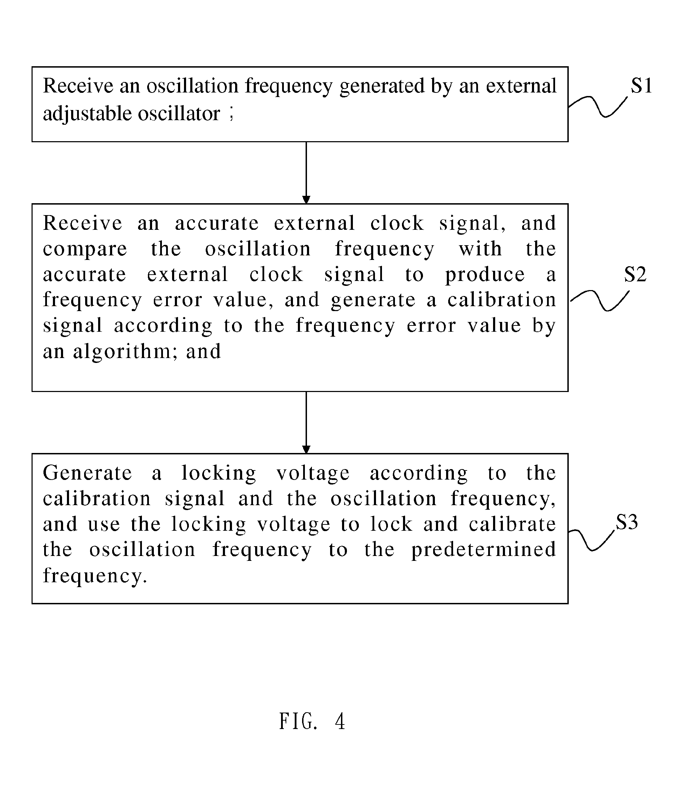

With reference to FIG. 4 for a flow chart of a method for locking and calibrating a frequency in accordance with a preferred embodiment of the present invention, the method is applied for locking an external adjustable oscillator to a predetermined frequency, wherein the external adjustable oscillator controls an oscillation frequency by a voltage, and the method comprises the following steps:

Step S1: Receive an oscillation frequency generated by an external adjustable oscillator.

Step S2: Receive a precise external clock frequency, and compare the oscillation frequency with the precise external clock frequency to calculate a frequency difference therebetween, and generate a calibration signal according to the frequency difference by an algorithm, wherein the algorithm is used for computing the calibration signal corresponding to the frequency difference and determining whether or not there is an error of the oscillation frequency according to the frequency difference. If there is an error of the oscillation frequency, the algorithm will generate a calibration signal corresponding to the frequency difference.

Step S3: Generate a locking voltage according to the calibration signal and the oscillation frequency, and use the locking voltage to lock the oscillation frequency to the predetermined frequency, wherein a frequency adjusting unit is set to generate the locking voltage according to a comparison result of the calibration signal and the oscillation frequency.

Compared with the prior art, the present invention provides a device and a method for locking and calibrating a frequency, and the device and method still can output a predetermined synchronous frequency precisely without the need of using a precise frequency oscillator or a processor with an additional hardware mechanism. In other words, the present invention can calibrate the synchronous frequency directly to achieve the effect of outputting the required synchronous frequency precisely and directly without the need of changing the original existing hardware.

In summation of the description above, the present invention complies with patent application requirements, and products derived from the present invention fully meet the present market requirements.

While the invention has been described by means of specific embodiments, numerous modifications and variations could be made thereto by those skilled in the art without departing from the scope and spirit of the invention set forth in the claims.

## Claims

1. A device for locking and calibrating a frequency, for receiving a precise external clock frequency to lock an external adjustable oscillator to a predetermined frequency, the external adjustable oscillator controlling an oscillation frequency by a voltage, and the device comprising:
a processing unit for comparing the oscillation frequency with the precise external clock frequency to calculate a frequency difference therebetween and generate a calibration signal according to the frequency difference; and
a frequency adjusting unit for generating a locking voltage according to the calibration signal and the oscillation frequency, and calibrating and locking the oscillation frequency to the predetermined frequency by the locking voltage.

2. The device for locking and calibrating a frequency of claim 1, wherein the precise external clock frequency is one selected from the group consisting of Network Time Protocol-based (NTP-based) signal, Precision Time Protocol-based (PTP-based) signal, GPS clock signal, and Set-top-Box clock signal.

3. The device for locking and calibrating a frequency of claim 1, wherein the predetermined frequency is 19.2MHz, used for providing a frequency required by wide band code division multiple access (WCDMA) or universal mobile telecommunications system (UMTS).

4. A method for locking and calibrating a frequency, for locking an external adjustable oscillator to a predetermined frequency, the external adjustable oscillator controlling an oscillation frequency by a voltage, the method comprising the steps of:
receiving an oscillation frequency generated by an external adjustable oscillator;
receiving a precise external clock frequency, comparing the oscillation frequency with the precise external clock frequency to calculate a frequency difference therebetween, and generating a calibration signal according to the frequency difference by an algorithm; and
generating a locking voltage according to the calibration signal and the oscillation frequency, and using the locking voltage to lock the oscillation frequency to the predetermined frequency.

5. The method for locking and calibrating a frequency as recited in claim 4, wherein the frequency difference is used for determining whether or not there is an error of the oscillation frequency.

6. The method for locking and calibrating a frequency as recited in claim 5, wherein if there is a frequency difference between the oscillation frequency and the precise external clock frequency, the algorithm generates the calibration signal corresponding to the frequency difference.

7. The method for locking and calibrating a frequency as recited in claim 6, further comprising: setting a frequency adjusting unit to generate the locking voltage according to a comparison result of the calibration signal and the oscillation frequency.
